# FASCICULE DE BREVET EUROPEEN

(11) **EP 0 520 897 B1**
(45) Date de publication et mention de la délivrance du brevet: **27.07.1994**
(21) Numéro de dépôt: 92401799.9
(22) Date de dépôt: 25.06.1992
(51) Int. Cl.: G01D 5/246, G01P 3/48, G01R 7/06

(54) **Dispositif de commande d'un indicateur électrique à bobines croisées, de type logomètre**
Steuereinrichtung für ein Kreuzspulanzeigegerät
Controller for a crossed-coil meter

(30) Priorité: 27.06.1991 FR 9107963
(43) Date de publication de la demande: 30.12.1992
(73) Titulaire: MARELLI AUTRONICA, 92000 Nanterre (FR)
(72) Inventeur: Wartelle, Dominique, F-31470 Fontenille (FR); Deschamps, Hervé, F-92150 Suresnes (FR); Marteau, Bernard, F-91430 Igny (FR)
(74) Mandataire: Martin, Jean-Jacques

(56) Documents cités:
- EP-A- 0 306 194
- PATENT ABSTRACTS OF JAPAN, vol. 11, no. 373 (P-643), 5 décembre 1987 & JP-A-62 144075

## Description

La présente invention concerne le domaine des dispositifs de commande des indicateurs électriques à bobines croisées, de type logomètre.

Les dispositifs indicateurs de type logomètre comprennent généralement plusieurs bobines croisées, soit de préférence deux bobines croisées à 90°, un axe guidé à rotation, un aimant solidaire de l'axe placé à l'intérieur des bobines, une aiguille indicatrice externe aux bobines et solidaire de l'axe, et des moyens de commande appliquant des signaux électriques aux bobines.

Le plus souvent les logomètres comprennent également une chambre fixe entourant l'aimant et contenant un liquide d'amortissement, dans lequel baigne l'aimant.

Chacune des bobines génère un champ magnétique proportionnel au courant qui la traverse. L'aimant se positionne selon la résultante de ces champs. Pour un logomètre à deux bobines, l'angle défini par l'aiguille indicatrice, par rapport à une position d'origine est donc déterminé par la relation tan⁻¹ I₁/I₂, dans laquelle I₁ et I₂ représentent des valeurs proportionnelles aux ampères-tours circulant respectivement dans les bobines.

Dans le domaine automobile, les logomètres à grande déviation sont utilisés généralement pour visualiser une vitesse ou le nombre de tours de rotation du moteur. Les logomètres à grande déviation comprennent généralement un spiral de rappel solidaire d'une part de l'axe, d'autre part du bati du logo.

La structure et le fonctionnement des logomètres sont bien connus de l'homme de l'art et ne seront donc pas décrits plus en détail par la suite.

La présente invention concerne plus précisément les moyens de commande conçus pour appliquer des signaux électriques appropriés sur les bobines d'un logomètre.

On a déjà proposé de nombreux moyens de commande à cet effet, par exemple dans les documents US-A-2057845, DE-A-853181, US-A-2500628, US-A-3168689, US-A-3327208, US-A-3329893, US-A-3624625, US-A-3636447, US-A-63732436, US-A-3946311, US-A-4051434, US-A-4070665, DE-A-2924617, US-A-4230984 et EP-A-0218737, ou encore dans le document au nom de la Demanderesse : FR-A-2640744.

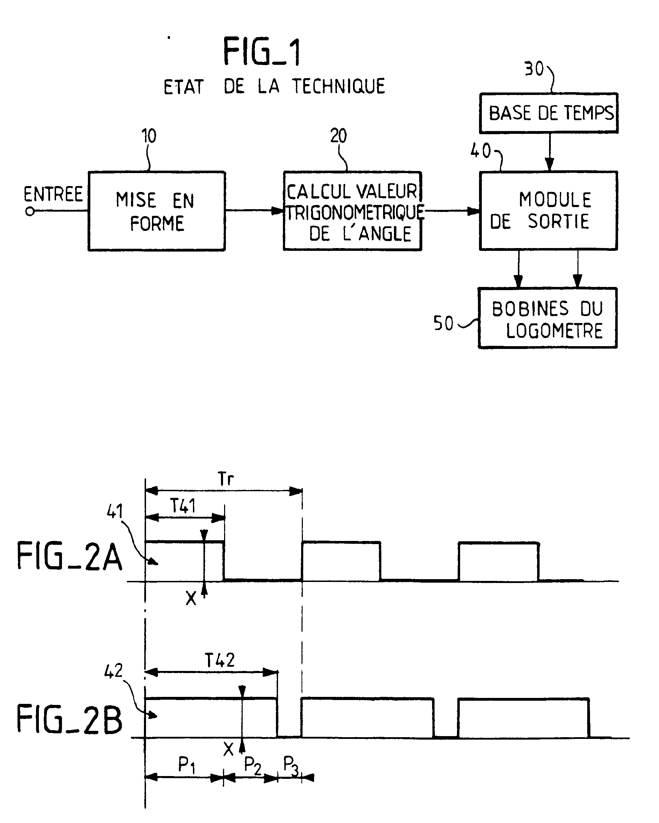

On a représenté sur la figure 1 annexée la structure d'un dispositif classique de commande de logomètre.

Le dispositif représenté sur la figure 1 comprend :
- un module de mise en forme 10 qui reçoit le signal d'entrée représentatif du paramètre à visualiser sur l'appareil indicateur,
- un module 20 conçu pour calculer une ou des valeurs trigonométriques sur la base du signal issu du module de mise en forme 10,
- une base de temps 30, et
- un module de sortie 40 cadencé par la base de temps 30 et qui génère les signaux électriques de commande appliqués aux bobines 50 du logomètre.

De façon connue en soi, les valeurs trigonométriques calculées par le module 20 peuvent être soit des fonctions en sinus et cosinus, soit des fonctions en tangente du signal issu du module de mise en forme 10.

Le module de sortie 40 produit généralement des signaux de sortie à fréquence de récurrence constante dont le rapport cyclique dépend des valeurs trigonométriques calculées par le module 20.

On a ainsi représenté sur les figures 2A et 2B annexées, les signaux de sortie du module 40, appliqués respectivement aux deux bobines d'un logomètre, dans le cas de signaux en sinus et cosinus calculés par le module 20.

Sur les figures 2A et 2B, la période de récurrence des signaux de sortie du module 40 est référencée Tr. Cette période de récurrence est définie par la base de temps 30.

Pendant chaque période de récurrence Tr une première sortie du module 40 produit un niveau logique 41 d'amplitude X constante, dont la durée T41 au niveau haut est proportionnelle au sinus de l'angle à visualiser : sinY, tandis qu'une seconde sortie du module 40 produit un niveau logique 42 d'amplitude X constante, dont la durée T42 au niveau haut est proportionnelle au cosinus de l'angle à visualiser : cosY.

Les créneaux logiques de sortie T41 et T42 sont appliqués respectivement aux deux bobines du logomètre.

L'aimant se positionne selon la résultante des champs, soit selon l'angle Y par rapport à une position d'origine.

On a souvent proposé d'utiliser une fréquence de récurrence 1/Tr élevée, supérieure aux fréquences mécaniques du logomètre, pour éviter les vibrations audibles. La fréquence de récurrence 1/Tr élevée généralement retenue est égale à 16kHz.

Bien que souvent utilisée, cette fréquence de récurrence de 16kHz ne donne pas totalement satisfaction : les vibrations mécaniques du logomètre étant supprimées, on constate que celui-ci présente de l'hystérésis.

Cette hystérésis se manifeste sous deux formes. Dans le cas d'une variation continue du paramètre d'entrée, l'angle visualisé, pour un paramètre d'entrée donné lors d'une réduction de celui-ci, diffère de l'angle visualisé pour le même paramètre d'entrée, lors d'une élévation de celui-ci. De plus, lorsque l'aimant et l'aiguille du logomètre sont immobilisés dans une position donnée correspondant à un paramètre d'entrée fixe, cet aimant et cette aiguille ne commenceront à se déplacer que pour une variation du paramètre d'entrée dépassant un seuil d'hystérésis.

On a tenté d'éliminer ces inconvénients en utilisant une fréquence de récurrence 1/Tr très inférieure aux fréquences mécaniques du logomètre, pour combattre l'hystérésis mécanique de celui-ci en autorisant une légère vibration de l'aimant et de l'aiguille du logomètre, tout en étant très supérieure aux fréquences visibles à l'oeil.

Plus précisément, on a ainsi proposé d'utiliser une fréquence de récurrence de 128Hz.

Toutefois, l'utilisation d'une fréquence basse de récurrence présente à son tour deux inconvénients importants.

Le premier inconvénient vient du fait qu'une fréquence basse de récurrence ne permet pas toujours de vaincre l'hystérésis en tous points. En particulier une fréquence basse de récurrence ne permet pas de vaincre l'hystérésis pour un angle à visualiser orienté selon une bissectrice des bobines (soit α modulo 90°=45° pour deux bobines orthogonales) ou orienté selon l'une des deux bobines (soit α modulo 90°=0° pour deux bobines orthogonales).

Cela semble dû au fait que pour vaincre efficacement l'hystérésis, il faut disposer de temps de créneaux au niveau haut, non nuls, et différents entre eux pour les deux signaux appliqués aux bobines du logomètre.

Ainsi par exemple, si l'on décompose chaque période de récurrence Tr représentée sur les figures 2A et 2B en trois phases successives :
- une phase P1 pendant laquelle les deux créneaux 41 et 42 sont au niveau haut, et le module de la résultante des champs est maximal,
- une phase P2 pendant laquelle le créneau 41 est au nivau bas tandis que le créneau 42 est au niveau haut, et
- une phase P3 pendant laquelle les deux créneaux 41 et 42 sont au niveau bas, on constate que :
   . pendant la phase P1, les signaux appliqués aux deux bobines étant identiques, l'aimant et l'aiguille tendent à s'orienter selon une bissectrice des axes des bobines,
   . pendant la phase P2, l'aimant et l'aiguille tendent à s'orienter vers l'axe de la bobine au niveau haut et s'en rapproche d'autant plus que cette durée est grande, et
   . pendant la phase P3, le couple électromagnétique est nul, l'aimant et l'aiguille tendent à être ramenés vers une position d'origine par un ressort spiral de rappel.

Toutefois, le couple de rappel appliqué pendant la phase P3 est très inférieur au couple magnétique appliqué pendant les phases P1 et P2. Les vibrations mécaniques aptes à vaincre l'hystérésis sont donc dues essentiellement à la présence successive des phases P1 et P2.

Or, dans le cas où l'angle à visualiser est orienté selon une bissectrice des bobines, la phase P2 est inexistante, tandis que dans le cas où l'angle à visualiser est orienté selon l'axe de l'une des bobines, la phase P1 est inexistante. Dans ces deux cas les vibrations mécaniques du logomètre sont négligeables et insuffisantes pour vaincre l'hystérésis.

Le deuxième inconvénient vient du fait qu'une fréquence basse de récurrence de l'ordre de 128Hz tombe dans la gamme des fréquences audibles. L'utilisation de cette fréquence de récurrence peut donc conduire à un bruit parasite, en particulier lorsque l'aiguille du logomètre vient reposer, en position minimale d'origine, contre une butée mécanique.

En effet, la plupart des logomètres ont une butée mécanique qui définit la position minimale d'origine, et cette butée mécanique est généralement placée au-delà du zéro électrique de l'appareil indicateur.

Pour tenter d'éliminer les inconvénients résultant de la fréquence de récurrence de 128Hz, il a été proposé d'utiliser une fréquence de récurrence plus élevée de 512Hz. Toutefois, cette fréquence de récurrence de 512Hz génère également des bruits parasites audibles.

Compte-tenu de ce qui a été exposé précédemment, la tendance actuelle est de revenir à une fréquence de récurrence élevée, typiquement 16kHz, pour éviter les bruits parasites audibles, quitte à tolérer une certaine hystérésis.

La présente invention a maintenant pour but de proposer de nouveaux moyens de commande de logomètres qui éliminent les inconvénients des dispositifs antérieurement connus.

Ce but est atteint selon la présente invention grâce à un dispositif de commande de logomètre du type comprenant :
- un module de calcul conçu pour calculer au moins une valeur trigonométrique sur la base d'un signal d'entrée,
- une base de temps, et
- un module logique de sortie qui produit des signaux de sortie à fréquence de récurrence constante dont le rapport cyclique dépend des valeurs trigonométriques calculées, ladite fréquence de récurrence étant contrôlée par la base de temps et supérieure aux fréquences mécaniques audibles du logomètre, caractérisé par le fait qu'il comprend en outre des moyens additionnels pour superposer une composante basse fréquence, de fréquence inférieure aux fréquences mécaniques du logomètre, sur les signaux de sortie.

Selon un mode de réalisation préférentiel les moyens conçus pour superposer une composante basse fréquence sur les signaux de sortie, comprennent un étage additionnel monté en amont du module de calcul et conçu pour calculer alternativement et avec une fréquence de récurrence égale à la basse fréquence, les valeurs A+dA et A-dA relations dans lesquelles A représente l'angle de déviation du logomètre correspondant au signal d'entrée.

Selon un mode de réalisation, les moyens conçus pour superposer une composante basse fréquence sur les signaux de sortie, comprennent un étage additionnel monté en aval du module de calcul et conçu pour alternativement, et avec une fréquence de récurrence égale à la basse fréquence, ajouter et retrancher une valeur dA aux valeurs trigonométriques calculées, avant d'appliquer celles-ci sur le module logique de sortie.

La valeur dA peut être soit un pourcentage prédéterminé de la valeur A, soit une constante.

D'autres caractéristiques, buts et avantages de la présente invention apparaîtront à la lecture de la description détaillée qui va suivre et en regard des dessins annexés donnés à titre d'exemples non limitatifs et sur lesquels :
- la figure 1 précédemment décrite, représente sous forme de blocs fonctionnels, la structure d'un dispositif de commande conforme à l'état de la technique,
- la figure 2 précédemment décrite, représente schématiquement des signaux connus de rapports cycliques modulés en sinus et cosinus, générés par le module de sortie d'un dispositif classique,
- la figure 3 représente sous forme de blocs fonctionnels la structure d'un dispositif de commande conforme à un mode de réalisation préférentiel de la présente invention,
- les figures 4A, 4B, 4C et 5A, 5B, 5C illustrent schématiquement des signaux de commande de bobines de logomètres, obtenus à l'aide du dispositif conforme à la présente invention, et
- la figure 6 représente, sous forme de blocs fonctionnels, une variante de réalisation du dispositif de commande conforme à la présente invention.

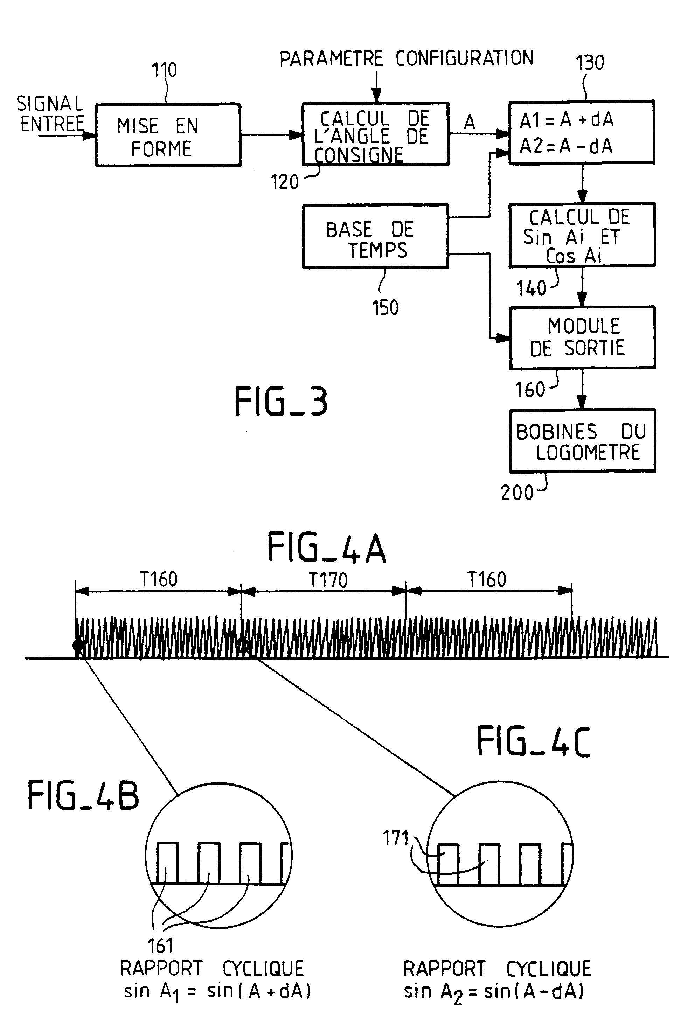

Le circuit de commande 100 conforme à la présente invention, qui est représenté sur la figure 3 annexée comprend un étage de mise en forme 110 du signal d'entrée, un module 120 de calcul d'un angle de consigne, un module 130 de superposition de composante basse fréquence, un module de calcul 140, une base de temps 150, et un module logique de sortie 160.

Les deux bobines du logomètre sont schématisées sous forme du bloc 200.

Le signal d'entrée représentant le paramètre à visualiser sur le logomètre est appliqué à l'entrée de l'étage 110.

Le plus souvent la valeur du paramètre à visualiser est codée par la fréquence du signal d'entrée. En effet, le capteur mesurant le paramètre à visualiser est souvent un capteur tachymétrique placé en sortie de boîte de vitesse d'un véhicule automobile, et qui génère un signal dont la fréquence est proportionnelle à la vitesse de rotation de ladite sortie de boîte de vitesse. Dans ce cas l'étage de mise en forme 110 est généralement formé d'un périodemétre.

Toutefois, la présente invention peut également s'appliquer aux cas où la valeur du paramètre à visualiser est codée par l'amplitude du signal d'entrée. Dans ce cas, l'étage 110 peut être formé par exemple d'un convertisseur Analogique/Numérique.

Le module 120 est conçu pour générer à sa sortie un signal A dont l'amplitude représente l'angle de consigne à visualiser. Pour cela le module 120 pondère le signal de sortie de l'étage 110 sur la base d'un paramètre de configuration E défini par les caractéristiques du système.

Le module 130 est cadencé par la base de temps 150 à une fréquence basse de récurrence, inférieure aux fréquences mécaniques du logomètre.

La fréquence de récurrence du module 130 est typiquement de l'ordre de 128Hz.

Plus précisément, le module 130 calcule alternativement, au rythme de ladite fréquence basse de récurrence, des valeurs A1 = A + dA et A2 = A - dA.

La valeur dA peut être soit proportionnelle à la valeur A issue du module 120, soit une constante. On peut par exemple prendre dA = 15°. La valeur dA peut être optimisée dans chaque cas particulier, en fonction des caractéristiques de l'aiguille et du logomètre.

Le module de calcul 140 calcule ensuite les valeurs trigonométriques sinAi (c'est-à-dire alternativement sinA1 et sinA2) et cosAi (c'est-à-dire alternativement cosA1 et cosA2).

Ces valeurs trigonométriques sont ensuite appliquées au module de sortie 160.

Ce module de sortie 160 est contrôlé par la base de temps 150.

Il produit les signaux de commande des bobines 200 du logomètre. Ces signaux de commande présentent une fréquence de récurrence qui est définie par la base de temps 150. Cette fréquence de récurrence est supérieure aux fréquences mécaniques audibles du logomètre. Elle est typiquement de l'ordre de 16kHz.

Les signaux de commande issus du module 160 possèdent une amplitude constante et un rapport cyclique qui dépend des valeurs trigonométriques calculées.

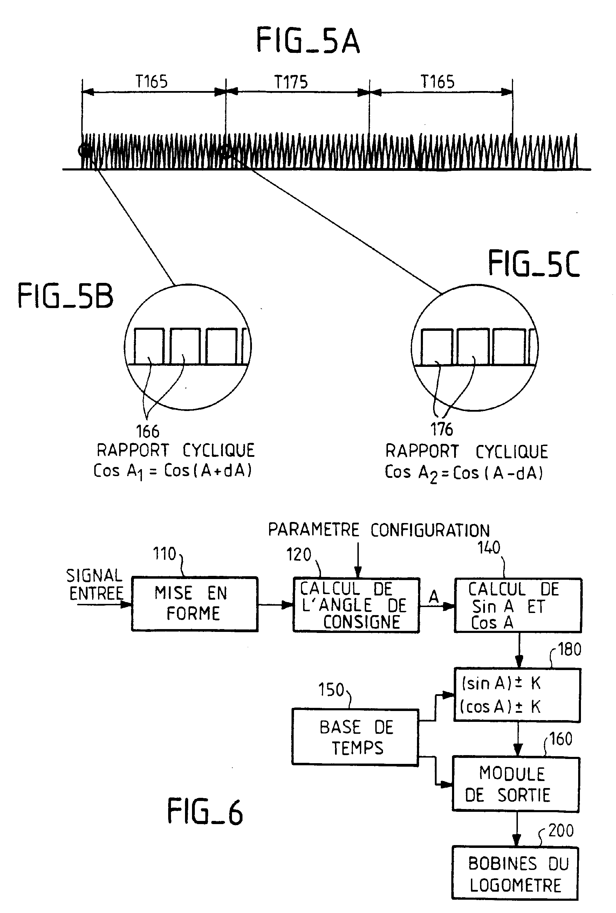

Les signaux de commande produits par le module de sortie 160 sont schématisés sur les figures 4A, 4B, 4C et 5A, 5B, 5C annexées.

On a schématisé sur la figure 4A les périodes successives d'un premier signal en sinus dont les périodes alternées T160, T170 sont cadencées à la fréquence basse de récurrence, typiquement à 128Hz.

Pendant les périodes paires T160, le signal comprend, comme représenté sur la figure 4B, des créneaux logiques 161, d'amplitude constante, cadencés à la fréquence haute de récurrence, typiquement 16kHz et dont le rapport cyclique est égal à sinA1 = sin(A+dA).

Pendant les périodes impaires T160, le signal comprend, comme représenté sur la figure 4C, des créneaux logiques 171, d'amplitude constante, cadencés à la fréquence haute de récurrence, typiquement 16kHz et dont le rapport cyclique est égal à sinA2 = sin(A-dA).

Ce premier signal est appliqué à une première bobine du logomètre.

On a de plus schématisé sur la figure 5A, les périodes successives d'un second signal en cosinus dont les périodes alternées T165, T175 sont cadencées à la fréquence basse de récurrence, typiquement à 128Hz.

Pendant les périodes paires T165, le second signal comprend comme représenté sur la figure 5B, des créneaux logiques 166, d'amplitude constante, cadencés à la fréquence haute de récurrence, typiquement 16kHz et dont le rapport cyclique est égal à cosA1 = cos(A+dA).

Pendant les périodes impaires T175, le signal comprend, comme représenté sur la figure 5C, des créneaux logiques 176, d'amplitude constante, cadencés à la fréquence haute de récurrence, typiquement 16kHz et dont le rapport cyclique est égal à cosA2 = cos(A-dA).

Ce second signal est appliqué à une seconde bobine du logomètre.

La superposition de la composante basse fréquence à 128Hz sur les signaux de commande permet de vaincre l'hystérésis du logomètre en tous points de l'affichage.

Cependant pour éviter tout bruit, selon une autre caractéristique avantageuse de la présente invention, le module 130 est conçu pour ne pas ajouter ou retrancher la valeur dA, à la valeur A, lorsque la valeur A est inférieure au zéro mécanique. Ainsi, on évite que l'aiguille ne vienne battre sur la butée mécanique formant le zéro mécanique.

Pour l'essentiel, les moyens 110, 120, 140 et 160 peuvent être conformes aux dispositions décrites et représentées dans le document FR-A-2640744, auquel on se réfèrera utilement.

Pour cette raison, la structure de ces moyens ne sera pas décrite en détail par la suite.

On indiquera simplement par la suite, les caractéristiques générales de ces moyens pour la bonne compréhension de la présente invention.

L'étage 110 peut comprendre un étage trigger recevant le signal d'entrée et un compteur, monté en périodemétre, qui compte le nombre d'impulsions issues d'une horloge entre deux fronts consécutifs de même type, par exemple deux fronts montants, du signal issu de l'étage trigger.

Le module 120 de calcul de l'angle de consigne peut comprendre un diviseur qui divise une constante E par la grandeur issue du compteur précité. La constante E est programmée de telle sorte que pour la valeur maximale admise de la fréquence d'entrée, la division de E par la valeur issue du compteur corresponde à l'angle maximal de déviation.

Le cas échéant, un filtre peut être intercalé entre la sortie du module 120 et l'entrée du module de calcul 130. Ce filtre peut être formé d'un module à moyenne glissante suivi d'un module limiteur de pente, comme décrit dans le document FR-A-2640744. Le filtre peut également être conforme aux dispositions décrites dans la demande de brevet FR-90 08334 déposée le 2 juillet 1990.

Le module de calcul 140 comprend de préférence des moyens de mémoire associés à un interpolateur.

Les moyens de mémoire contiennent des valeurs grossières de sin et cos sur des quadrants de 90°. Ils sont adressés par les bits de poids intermédiaires des signaux issus du module 130. Ces valeurs grossières sont affinées par l'interpolateur sur la base des bits de poids faibles de ces mêmes signaux.

Le module de sortie 160 qui détermine les rapports cycliques des signaux appliqués aux bobines comprend de préférence des registres décompteurs. Ceux-ci sont chargés périodiquement aux valeurs issues du module 140, puis les registres décompteurs sont décrémentés à une fréquence fixe. On obtient ainsi en sortie des registres décompteurs des signaux logiques, dont la durée au niveau haut est proportionnelle au sinus et au cosinus respectivement de l'angle de déviation recherché.

Enfin généralement des étages de puissance transistorisés sont intercalés entre la sortie des registres décompteurs et les bobines du logomètre.

La logique qui pilote les étages de puissance transistorisés, est pilotée par les deux bits de poids forts des signaux issus du module 130. Ces deux bits de poids forts permettent en effet de coder les quatre quadrants d'un affichage pleine échelle et de contrôler en conséquence le sens de courant dans les bobines du logomètre. Les étages de puissance transistorisés comprennent de préférence huit transistors, soit une paire de transistors associée à chaque extrémité de bobine.

La description qui précède concerne une commande des bobines du logomètre par des signaux en sinus et cosinus dont les valeurs trigonométriques sont calculées par le module 140.

Cependant en variante on peut commander les bobines du logomètre par des signaux en tangente et non pas par des signaux en sinus et cosinus.

Dans ce cas, les moyens de mémoire du module 140 contiennent des valeurs de tangente échantillonnées sur 45°, la déviation maximale de 360° étant codée en huit octants de 45° par les trois bits de poids forts issus du module 130.

L'une des bobines reçoit alors un courant dont le rapport cyclique est proportionnel à la tangente obtenue, tandis que l'autre bobine reçoit un courant de référence de rapport cyclique constant égal au courant appliqué à la première bobine pour 45°.

Le sens des courants et la nature des signaux appliqués sur les bobines sont alternés d'un octant à l'autre sur la base des trois bits de poids forts du signal issu du module 130, comme décrit dans le principe dans le document FR-A-2640744.

La présente invention n'est pas limitée au mode de réalisation représenté sur la figure 3, qui vient d'être décrit, mais s'étend à toute variante conforme à son esprit.

Ainsi par exemple, comme représenté sur la figure 6 annexée, le module 130 intercalé entre les deux modules 120 et 140 peut être supprimé et remplacé par un module 180 intercalé entre le module de calcul 140 et le module de sortie 160.

Le module 180, à une fréquence de récurrence égale à la basse fréquence, soit typiquement à 128Hz, ajoute et retranche alternativement une valeur K aux valeurs trigonométriques calculées par le module 140, avant d'appliquer celles-ci sur le module logique de sortie 160.

Ainsi pour une commande en sinus et cosinus, pendant les périodes paires de la fréquence de récurrence à 128Hz, le module 180 calcule les valeurs (sinA) + K et (cosA) + K, tandis que pendant les périodes impaires de la fréquence de récurrence à 128Hz, le module 180 calcule les valeurs (sinA) - K et (cosA) - K.

Pour une commande en tangente, pendant les périodes paires de la fréquence de récurrence à 128Hz, le module 180 calcule la valeur (tgA) + K, tandis que pendant les périodes impaires de la fréquence de récurrence à 128Hz, le module 180 calcule la valeur (tgA) - K.

K est une valeur choisie expérimentalement, soit fixe, soit dépendante de la valeur de l'angle A.

Là encore le module 180 est conçu pour ne pas ajouter ou retrancher la valeur K, aux valeurs trigonométriques sinA et cosA ou tgA, lorsque la valeur A est inférieure à un certain angle, généralement égal à la position du zéro mécanique. Ainsi on évite que l'aiguille ne vienne battre sur la butée mécanique formant le zéro mécanique.

## Revendications

1. Dispositif de commande de logomètre du type comprenant :
- un module de calcul (140) conçu pour calculer au moins une valeur trigonométrique sur la base d'un signal d'entrée,
- une base de temps (150), et
- un module logique de sortie (160) qui produit des signaux de sortie à fréquence de récurrence constante dont le rapport cyclique dépend des valeurs trigonométriques calculées, ladite fréquence de récurrence étant contrôlée par la base de temps (150) et supérieure aux fréquences mécaniques audibles du logomètre (200), caractérisé par le fait qu'il comprend en outre des moyens additionnels (130, 180) pour superposer une composante basse fréquence, de fréquence inférieure aux fréquences mécaniques du logomètre, sur les signaux de sortie.

2. Dispositif selon la revendication 1, caractérisé par le fait que les moyens additionnels (130, 180) sont conçus pour ne pas superposer la composante basse fréquence sur les signaux de sortie lorsque la valeur du signal d'entrée est inférieure au zéro mécanique du logomètre (200).

3. Dispositif selon l'une des revendications 1 ou 2, caractérisé par le fait que les moyens (130) conçus pour superposer une composante basse fréquence sur les signaux de sortie, comprennent un étage monté en amont du module de calcul (140) et conçu pour calculer alternativement et avec une fréquence de récurrence égale à la basse fréquence, les valeurs A+dA et A-dA, relations dans lesquelles A représente l'angle de déviation du logomètre correspondant au signal d'entrée.

4. Dispositif selon l'une des revendications 1 ou 2, caractérisé par le fait que les moyens (180) conçus pour superposer une composante basse fréquence sur les signaux de sortie, comprennent un étage monté en aval du module de calcul (140) et conçu pour alternativement, et avec une fréquence de récurrence égale à la basse fréquence, ajouter et retrancher une valeur K aux valeurs trigonométriques calculées, avant d'appliquer celles-ci sur le module logique de sortie.

5. Dispositif selon la revendication 3, caractérisé par le fait que la valeur dA est un pourcentage prédéterminé de l'angle de déviation A.

6. Dispositif selon la revendication 3, caractérisé par le fait que la valeur dA est une constante.

7. Dispositif selon la revendication 6, caractérisé par le fait que la valeur dA est de l'ordre de 15°.

8. Dispositif selon l'une des revendications 1 à 7, caractérisé par le fait que la fréquence de récurrence élevée supérieure aux fréquences mécaniques audibles du logomètre est de l'ordre de 16kHz.

9. Dispositif selon l'une des revendications 1 à 8, caractérisé par le fait que la fréquence de récurrence basse inférieure aux fréquences mécaniques audibles du logomètre est de l'ordre de 128Hz.

10. Dispositif selon l'une des revendications 1 à 9, caractérisé par le fait que les valeurs trigonométriques calculées sont des fonctions sinus et cosinus.

11. Dispositif selon l'une des revendications 1 à 9, caractérisé par le fait que les valeurs trigonométriques calculées sont des fonctions tangentes.

## Patentansprüche

1. Vorrichtung zum Steuern eines Quotientenmessers mit
- einem Rechenmodul (140), der so ausgebildet ist, daß er wenigstens einen trigonometrisch Wert auf der Grundlage eines Eingangssignals berechnet,
- einer Zeitbasis (150), und
- einem logischen Ausgangsmodul (160), der Ausgangssignale mit einer konstanten Wiederholungsfrequenz erzeugt, deren zyklisches Verhältnis von den berechneten trigonometrischen Werten abhängt, wobei die Wiederholungsfrequenz über die Zeitbasis (150) gesteuert wird und über den hörbaren mechanischen Frequenzen des Quotientenmessers (200) liegt, dadurch gekennzeichent, daß sie zusätzliche Einrichtungen (130, 180) zum Überlagern der Ausgangssignale mit einem niederfrequenten Anteil aufweist, dessen Frequenz unter den mechanischen Frequenzen des Quotientenmessers liegt.

2. Vorrichtung nach Anspruch 1, dadurch gekennzeichent, daß die zusätzlichen Einrichtungen (130, 180) so ausgebildet sind, daß sie die Ausgangssignale nicht mit dem niederfrequenten Anteil überlagern, wenn der Wert des Eingangssignals unter dem mechanischen Nullpunkt des Quotientenmessers (200) liegt.

3. Vorrichtung nach einem der Ansprüchen 1 und 2, dadurch gekennzeichnet, daß die Einrichtungen (130), die so ausgebildet sind, daß sie die Ausgangssignale mit dem niederfrequenten Anteil überlagern, eine Stufe umfassen, die dem Rechenmodul (140) vorgeschaltet und so ausgebildet ist, daß sie abwechselnd und mit einer Wiederholungsfrequenz gleich der Niederfrequenz die Werte A+dA und A-dA berechnet, wobei in diesen Beziehungen A den Ausschlagwinkel des Quotientenmessers wiedergibt, der dem Eingangssignal entspricht.

4. Vorrichtung nach einem der Ansprüche 1 und 2, dadurch gekennzeichent, daß die Einrichtungen (180), die so ausgebildet sind, daß sie die Ausgangssignale mit einem niederfrequenten Anteil überlagern, eine Stufe umfassen, die dem Rechenmodul (140) vorgeschaltet und so ausgebildet ist, daß sie abwechselnd und mit einer Wiederholungsfrequenz gleich der Niederfrequenz einen Wert K den berechneten trigonometrischen Werten zuaddiert und davon abzieht und danach diese an den logischen Ausgangsmodul legt.

5. Vorrichtung nach Anspruch 3, dadurch gekennzeichent, daß der Wert dA ein bestimmter prozentualer Anteil des Ausschlagwinkels A ist.

6. Vorrichtung nach Anspruch 3, dadurch gekennzeichnet, daß der Wert dA eine Konstante ist.

7. Vorrichtung nach Anspruch 6, dadurch gekennzeichnet, daß der Wert dA in der Größenordnung von 15° liegt.

8. Vorrichtung nach einem der Ansprüchen 1 bis 7, dadurch gekennzeichnet, daß die Wiederholungsfrequenz, die über den hörbaren mechanischen Frequenzen des Quotientenmessers liegt, in der Größenordnung von 16kHz liegt.

9. Vorrichtung nach einem der Ansprüche 1 bis 8, dadurch gekennzeichnet, daß die Wiederholungsfrequenz, die unter den hörbaren mechanischen Frequenzen des Quotientenmessers liegt, in der Größenordnung von 128 Hz liegt.

10. Vorrichtung nach einem der Ansprüche 1 bis 9, dadurch gekennzeichent, daß die berechneten trigonometrischen Werte Sinus- und Kosinus-Funktionswerte sind.

11. Vorrichtung nach einem der Ansprüche 1 bis 9, dadurch gekennzeichnet daß die berechneten trigonometrischen Werte Tangens-Funktionswerte sind.

## Claims

1. Ratio meter control device of the type comprising:
- a calculation module (140) designed for calculating at least one trigonometric value on the basis of an input signal,
- a time base (150), and
- an output logic module (160) which produces output signals at a constant recurrence frequency, the duty cycle of which depends on the calculated trigonometric values, the said recurrence frequency being controlled by the time base (150) and higher than the audible mechanical frequencies of the ratio meter (200), characterized in that it further comprises additional means (130, 180) for superimposing a low-frequency component, of frequency lower than the mechanical frequencies of the ratio meter, on the output signals.

2. Device according to Claim 1, characterized in that the additional means (130, 180) are designed not to superimpose the low-frequency component on the output signals when the value of the input signal is lower than the mechanical zero of the ratio meter (200).

3. Device according to one of Claims 1 or 2, characterized in that the means (130) designed to superimpose a low-frequency component on the output signals comprise a stage mounted upstream from the calculation module (140) and designed to calculate, alternately and with a recurrence frequency equal to the low frequency, the values A+dA and A-dA, relationships in which A represents the deviation angle of the ratio meter corresponding to the input signal.

4. Device according to one of Claims 1 or 2, characterized in that the means (180) designed to superimpose a low-frequency component on the output signals comprise a stage mounted downstream from the calculation module (140) and designed alternately to add and subtract a value K, with a recurrence frequency equal to the low frequency, to and from the calculated trigonometric values, before applying the latter to the output logic module.

5. Device according to Claim 3, characterized in that the value dA is a predetermined percentage of the deviation angle A.

6. Device according to Claim 3, characterized in that the value dA is a constant.

7. Device according to Claim 6, characterized in that the value dA is of the order of 15°.

8. Device according to one of Claims 1 to 7, characterized in that the high recurrence frequency, higher than the audible mechanical frequencies of the ratio meter, is of the order of 16 kHz.

9. Device according to one of Claims 1 to 8, characterized in that the low recurrence frequency, lower than the audible mechanical frequencies of the ratio meter, is of the order of 128 Hz.

10. Device according to one of Claims 1 to 9, characterized in that the calculated trigonometric values are sine and cosine functions.

11. Device according to one of Claims 1 to 9, characterized in that the calculated trigonometric values are tangent functions.
